# FASCICULE DE BREVET EUROPEEN

(11) **EP 0 996 180 B1**
(45) Date de publication et mention de la délivrance du brevet: **14.01.2004**
(21) Numéro de dépôt: 98120044.7
(22) Date de dépôt: 23.10.1998
(51) Int. Cl.: H01M 2/10, H01M 2/20, H05K 5/00, H05K 3/30

(54) **Support de pile-bouton à positionnement vertical**
Knopfzellenträger mit vertikaler Positionierung
Button cell support with vertical positioning

(43) Date de publication de la demande: 26.04.2000
(73) Titulaire: Renata AG, 4452 Itingen (CH)
(72) Inventeur: Rieder, Stefan, 4207 Brekwil (CH)
(74) Mandataire: Thérond, Gérard Raymond

(56) Documents cités:
- WO-A-97/08764
- WO-A-98/19354
- BE-A- 903 314
- GB-A- 2 292 635

## Description

La présente invention a pour objet un support pour pile-bouton, à positionnement vertical sur une surface plane telle qu'une plaquette de circuit imprimé.

En raison de leur encombrement réduit, les piles-boutons sont d'un usage très répandu en tant que source d'énergie électrique des circuits intégrés d'appareils électroniques.

Dans les montres électroniques, les piles-boutons sont toujours disposées horizontalement, soit dans un logement ménagé dans le circuit imprimé disposé à l'intérieur de la boîte, soit dans une trappe prévue dans le fond de la boîte et obturée par un couvercle pour rendre plus facile le remplacement de la pile lorsqu'elle est usée. Les connexions des bornes de la pile au circuit électronique sont réalisées au moyen de brides métalliques, fixées à demeure au circuit imprimé ou au bâti, et en contact élastique avec l'une ou l'autre face de la pile-bouton ou avec le bord de son boîtier.

Pour des appareils électroniques de dimensions un peu plus grandes, tels que les téléphones mobiles ou les ordinateurs, il est apparu économiquement plus avantageux de fabriquer séparément un circuit imprimé et un container de pile, puis de procéder à l'assemblage mécanique et électrique de ces deux éléments. Dans le prolongement de la technologie existante pour les montres électroniques, de tels containers sont conçus généralement pour permettre un positionnement horizontal de la pile-bouton sur un circuit imprimé. Les brides de jonction entre le circuit imprimé et la pile sont formées par des lames métalliques ayant des découpes et des pliages relativement complexes, lesdites lames étant fixées en place depuis l'intérieur du boîtier. Un tel agencement est par exemple représenté par le container décrit dans le document GB 2 292 635. Le positionnement horizontal présente l'avantage d'avoir un encombrement réduit en hauteur et de conférer au container une bonne stabilité, qui peut encore être accrue par l'adjonction de pattes d'encliquetage formées dans le container, comme décrit par exemple dans le document WO 97/44836.

Une telle disposition horizontale présente toutefois au moins deux inconvénients. La place occupée sur le circuit imprimé est relativement importante, ce qui contribue à augmenter le coût du produit final alors que l'espace disponible dans la direction verticale est généralement tout à fait suffisant dans ces appareils pour positionner verticalement un container destiné à recevoir une pile-bouton. La mise en place, et surtout l'extraction de la pile-bouton sont assez malaisées, même si le container a une face entièrement, ou partiellement, ouverte vers l'extérieur. Certains fabriquants, tel que la société Sony Electronics Inc., proposent dans leur gamme de produits des containers pouvant être positionnés verticalement, mais dont la conformation est sensiblement la même que celle des containers à positionnement horizontal, à l'exception des pattes de fixation des brides de contact qui présentent des pliures supplémentaires ou différentes. De tels containers présentent les mêmes inconvénients que ceux évoqués précédemment pour le montage des brides depuis l'intérieur du container et pour la mise en place/extraction de la pile.

La présente invention vise à éviter les inconvénients susmentionnés grâce à un container à positionnement vertical ayant des brides de pile de forme simple et pouvant être montées sur ledit container depuis sa surface extérieure.

A cet effet l'invention a pour objet un support de pile-bouton à positionnement vertical sur une surface plane comprenant
- un container en matière isolante, ouvert vers le haut et délimité par une base rectangulaire, deux petites parois et deux grandes parois verticales, et
- une première bride et une deuxième bride métalliques solidaires du container pour relier électriquement les pôles positif et négatif de la pile à des contacts ménagés sur la surface plane.

Chaque grande paroi du container est pourvue d'un logement pour assujettir verticalement une bride depuis l'extérieur. Ce logement est formé d'une part d'une paroi de séparation comportant une découpe de communication avec l'intérieur du container et d'autre part de deux bandes verticales reliant les petites parois et d'une bande horizontale reliant la base, lesdites bandes étant parallèles à la paroi de séparation. Ces bandes délimitent une ouverture vers l'extérieur en formant des moyens d'encliquetage de la bride et des décrochements verticaux qui serviront de guidage. La bande horizontale est en outre pourvue d'au moins un passage traversant au delà de la base. La bride est formée par une lame métallique flexible prolongée à l'une de ses extrémités par au moins une patte de connexion engagée dans un passage traversant, présentant au niveau de la découpe de communication une partie déformée en coude vers l'intérieur du container, et ayant sur chacun de ses bords des moyens d'encliquetage complémentaires de ceux des bandes, mais décalés verticalement par rapport à ceux-ci pour permettre la mise en place de la bride en la faisant glisser de haut en bas.

Selon un mode de realisation préféré, les moyens d'encliquetage complémentaires sont formés de façon simple et économique par au moins une extension rectangulaire du bord de chaque bande verticale et par au moins une encoche de même dimension pratiquée dans chaque bord de la bride, dont la largeur maximum correspond sensiblement à la distance entre les décrochements verticaux de chaque côté du logement. La bride est réalisée en un métal flexible et pour la monter dans le logement, on fait coïncider les encoches et les extensions rectangulaires, puis on fait glisser la bride le long des décrochements verticaux jusqu'à ce qu'elle vienne en butée avec le fond du logement, ce qui modifie la position relative des encoches et des extensions et permet le positionnement vertical de chaque bride.

Même s'il est possible de réaliser un ajustement à frottement entre le fond des décrochements et les bords de la bride, selon un autre aspect de l'invention on condamne le déplacement vertical de la bride en prévoyant sur celle-ci des moyens d'ancrage qui résisteront par exemple à la pression transmise par les pattes lors de la fixation du support sur un circuit imprimé. A titre non limitatif ces moyens d'ancrage consistent en une languette découpée dans la bride et courbée vers la paroi de séparation, ou en un bossage formé dans la paroi de séparation et venant s'engager dans un évidemment pratiqué dans la bride. Il est bien sûr possible d'utiliser en même temps plusieurs moyens d'ancrage différents.

Les brides peuvent avoir la même configuration et ne posséder chacune qu'une patte de connexion. Il est toutefois avantageux de pouvoir différencier, selon un principe connu par ailleurs, le pôle positif de la pile, généralement en prévoyant deux pattes de connexion, du pôle négatif n'en comportant qu'une seule.

On observera également que, contrairement aux support à positionnement horizontal, les pattes de connexion sont éloignées de toute zone de pliure ou de déformation, ce qui permet de fixer de façon plus précise leur position relative par rapport aux contacts du circuit imprimé dans lequel elles devront être engagées.

Pour maintenir la pile-bouton en place à l'intérieur du container, il est possible de prévoir un couvercle venant s'emboîter ou s'encliqueter, par exemple au niveau des extensions rectangulaires du bord du logement. Toutefois, selon un mode de réalisation préféré qui évite la fabrication d'une pièce supplémentaire, la pile-bouton est maintenue dans le container par pliage d'une languette prolongeant la bride positive au-delà de la partie déformée en coude pour établir le contact avec une face de la pile.

Dans le cas où on souhaite obtenir une tension de sortie plus élevée, il est connu de remplacer une pile-bouton par deux piles-boutons mise en série et ayant ensemble la même épaisseur que la pile unique. Selon un autre aspect de l'invention ce but est facilement atteint en prévoyant un manchon isolant sur la partie recourbée de la languette, c'est-à-dire sans modification fondamentale du support de pile.

De même il est connu de prévoir un logement de pile exactement adapté aux dimensions asymétriques d'une pile-bouton, dont le couvercle a toujours un diamètre inférieur à celui du boîtier. Dans les supports de pile-bouton tels que ceux cités au début dans l'art antérieur, qu'ils soient positionnés verticalement ou horizontalement, la partie du container recevant la pile peut être conformée exactement aux dimensions de ladite pile, mais la lame élastique en appui sur une des ses faces pour la maintenir en place ne prévient pas totalement une introduction avec une inversion de polarité. Selon un autre aspect de l'invention, l'intérieur du container comporte deux arêtes interdisant totalement l'introduction d'une pile dans un sens non approprié.

D'autres caractéristiques et avantages de la présente invention apparaîtront dans la description suivante d'un exemple de réalisation donné à titre non limitatif, en référence aux dessins dans lesquels :
- la figure 1 est une représentation en perspective éclatée d'un support selon l'invention destiné à recevoir une pile-bouton,
- la figure 2 est une vue de face, du côté de la bride négative, d'un support selon l'invention destiné à recevoir une ou deux piles-boutons,
- la figure 3 est une coupe selon la ligne III-III de la figure 2,
- la figure 4 est une vue de dessus du support représenté à la figure 2, dans laquelle les brides de connexion ne sont pas représentées, et
- la figure 5 est une représentation en perspective éclatée d'un container obtenu par assemblage de deux pièces.

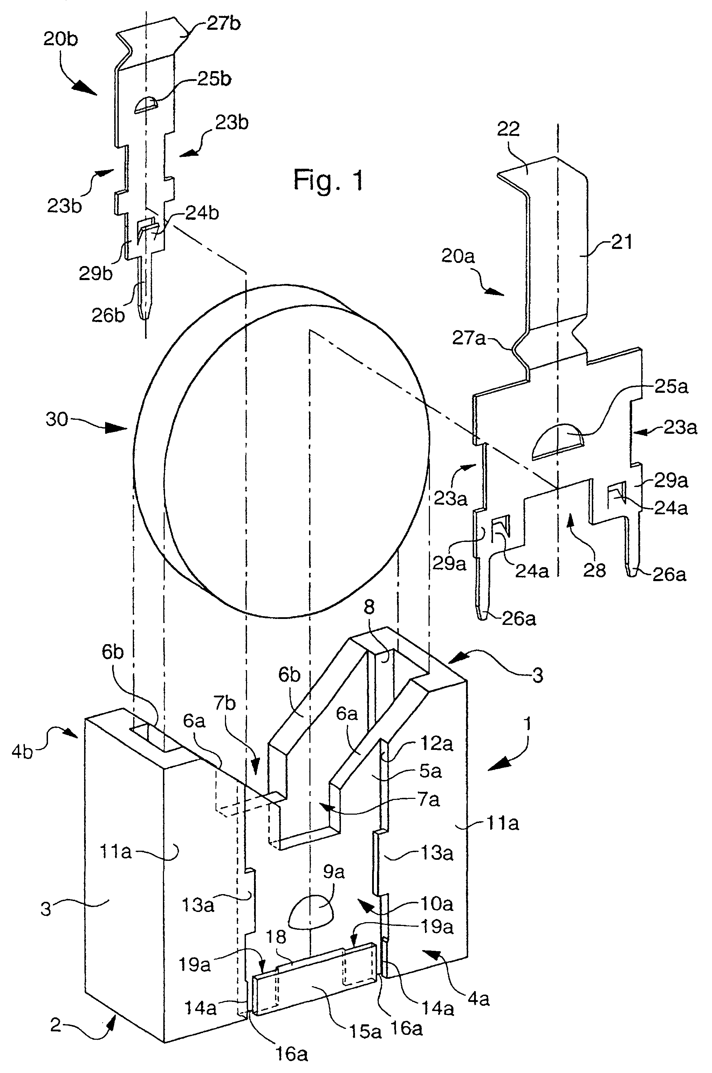

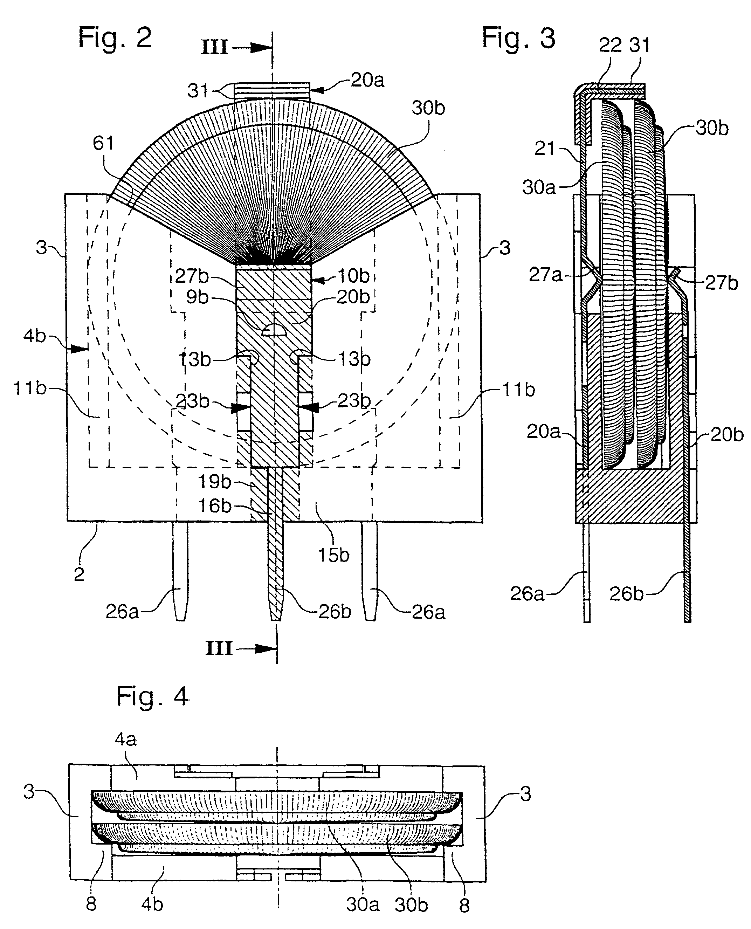

La figure 1 représente en vue éclatée un support de pile-bouton comprenant un container 1, deux brides de connexion 20a, 20b et une pile-bouton 30. Le container 1 est obtenu par moulage ou injection d'une matière plastique en une seule pièce ou en plusieurs pièces ultérieurement assemblées comme cela sera expliqué plus loin. Ce container 1 permet de fixer depuis l'extérieur deux brides de connexion 20a, 20b qui permettent de connecter électriquement une pile 30 lorsqu'elle est introduite dans le container 1. Le container 1 a une forme généralement parallélépipédique, la base 2 rectangulaire étant surmontée par deux petites parois 3, et par deux grandes parois 4a, 4b (visible sur la figure 2) qui comprennent chacune un logement 10a (respectivement 10b, non visible sur la figure 1). En se référant seulement au logement 10a, destiné à recevoir une bride 20a ayant deux pattes de connexion 26a, on voit qu'il est formé par une paroi de séparation 5a qui sépare le logement 10a de l'intérieur du container 1, et qui comporte une découpe de communication 7a, de forme sensiblement rectangulaire et symétrique par rapport au plan médian parallèle aux petites parois 3 du container 1. Cette découpe de communication 7a est prolongée de façon symétrique par des plans inclinés 6a qui rejoignent les bords supérieurs de l'ouverture du container 1. Vers l'extérieur, le contour du logement 10a est délimité par deux bandes verticales 11a qui rejoignent les petites parois 3 et qui ont une configuration symétrique par rapport au plan médian parallèle aux petites parois 3, et par une bande horizontale 15a qui rejoint le fond 2, lesdites bandes 11a, 15a étant parallèles à la paroi de séparation 5a. Chaque bande verticale 11a est plaquée contre la paroi de séparation 5a, ou vient de matière avec celle-ci, en formant sur chaque bord orienté vers le milieu du logement 10a un décrochement vertical 12a qui servira de guide pour les bords de la bride 20a.

Le bord de chaque bande 11a n'est pas rectiligne mais présente au moins une extension orientée vers l'axe médian du logement 10a. Dans l'exemple représenté, il existe sur le bord de chaque bande 11a une première extension rectangulaire 13a dans la partie médiane, et une deuxième extension 14a de plus petites dimensions dans la partie rejoignant le fond 2. Ces extensions 13a, 14a vont permettre d'encliqueter une bride 20a comme cela sera expliqué par la suite, et leur nombre et leur forme géométrique ne sont pas déterminants dans le cadre de la présente invention; le même but serait atteint, par exemple, par une succession d'extensions en dents de scie.

La bande horizontale 15a est plaquée sur une partie 18 de sa longueur, contre la paroi de séparation 5a ou vient de matière avec celle-ci, en ménageant, sur les côtés en regard des bandes verticales 11a et jusqu'à la paroi de séparation 5a, un passage traversant 16a qui débouche dans le fond 2 du container 1. Cette bande horizontale 15a comporte en outre, de chaque côté des passages traversants 16a, des feuillures 19a fermées à l'extérieur et dont l'écartement par rapport à la paroi de séparation 5a correspond sensiblement à l'épaisseur de la bride 20a.

La bride 20a est formée par une lame métallique pourvue de deux pattes de connexion 26a à l'une de ses extrémités, et prolongée à l'autre extrémité par une languette 21 plus étroite, présentant au niveau du raccordement avec la lame une déformation en coude 27a et ayant son extrémité 22 recourbée à 90° pour maintenir la pile 30 en place. Chaque bord de la lame comporte une encoche 23a ayant la même forme que l'extension correspondante 13a, qui est donc rectangulaire dans cet exemple. La partie inférieur de la lame comprend en outre une découpe 28, de forme complémentaire à la partie 18 de la bande 15a, qui délimite de part et d'autre deux parties 29a de lame qui viendront s'engager dans les feuillures 19a. Comme on le voit sur la figure 1, la bride 20a comprend également des moyens d'ancrage qui fixeront à demeure ladite bride 20a après sa mise en place dans le logement 10a. A titre principal, ces moyens d'ancrage sont formés par des petites languettes 24a découpées dans les parties 29a de la lame et recourbées vers la paroi de séparation 5a. Ces petites languettes 24a pourraient bien entendu être prévues en d'autres endroits de la lame, et en plus grand nombre, voire découpée dans les bords de la lame en contact avec les décrochement 12a (non représenté sur la figure 1). A titre complémentaire ou alternatif la lame peut comporter un évidemment 25a, par exemple semi-circulaire qui viendra s'engager dans un bossage 9a formé sur la paroi de séparation 5a. On observera que la lame peut parfaitement comporter un évidemment 25a, sans bossage correspondant 9a, ledit évidemment étant encore utile dans une chaîne de montage automatisé du support de pile pour l'approvisionnement et la mise en place de la bride.

La bride 20b est construite de façon analogue, mais ne comporte qu'une seule patte de connexion 26b et ne possède pas une languette s'étendant au-delà de la partie 27b recourbée en coude.

La grande paroi 4b, non visible dans la vue en perspective de la figure 1, est représentée de face à la figure 2, dans laquelle les brides 20a, 20b sont mises en place, ainsi que deux piles-boutons 30a, 30b disposées en série. Cette grande paroi 4b a une construction similaire à celle qui vient d'être décrite mais en diffère en ce que le logement 10b est conçu pour recevoir une bride 20b plus étroite que la bride 20a et ne comporte qu'une seule patte de connexion 26b. Pour une meilleure compréhension le contour de l'ouverture du logement 10b est représenté en trait continu renforcé et toute la surface de la bride 20b, dans ses parties visibles et non visibles, est hachurée.

La bande inférieure 15b ne comporte plus qu'un seul passage traversant 16a en position centrale. Les feuillures 19b sont disposées de chaque côté du passage 16a de sorte que chaque portion de bande 15b, de part et d'autre dudit passage 16a, n'est en fait qu'une extension des bandes verticales 11b. La figure 2 montre aussi clairement que, après assemblage de la bride 20b dans le logement 10b, les moyens complémentaires d'encliquetage, c'est-à-dire les extensions rectangulaires 13b et les encoches correspondantes 23b sont décalées axialement et que la partie inférieure 29b de la bride 20b est engagée dans les feuillures 19b.

En se référant maintenant aux figures 2 et 3, on voit que le support de pile-bouton qui vient d'être décrit peut loger deux piles-boutons 30a, 30b, et que l'extrémité recourbée 22 de la languette 21 est alors revêtue d'un manchon isolant 31. Le pont électrique entre les deux piles 30a, 30b mises en série s'effectue alors uniquement par les contacts établis respectivement sur les pôles positif et négatif, par les parties déformées en coude 27a, 27b des deux brides 20a, 20b.

La figure 4, qui est une vue de dessus correspondant à la figure 2 sans les brides 20a, 20b, montre encore plus clairement que la figure 1 comment les nervures 8 interdisent la mise en place d'un ou de deux piles-boutons dans un sens non approprié.

Comme cela a été dit, le support de pile selon l'invention peut être fabriqué de façon très économique. Les brides de connexion 20a, 20b sont obtenues à partir d'une bande ou d'une plaque métallique par des opérations d'estampage ou d'usinage bien connues de l'homme de l'art qui ne seront pas décrites plus avant.

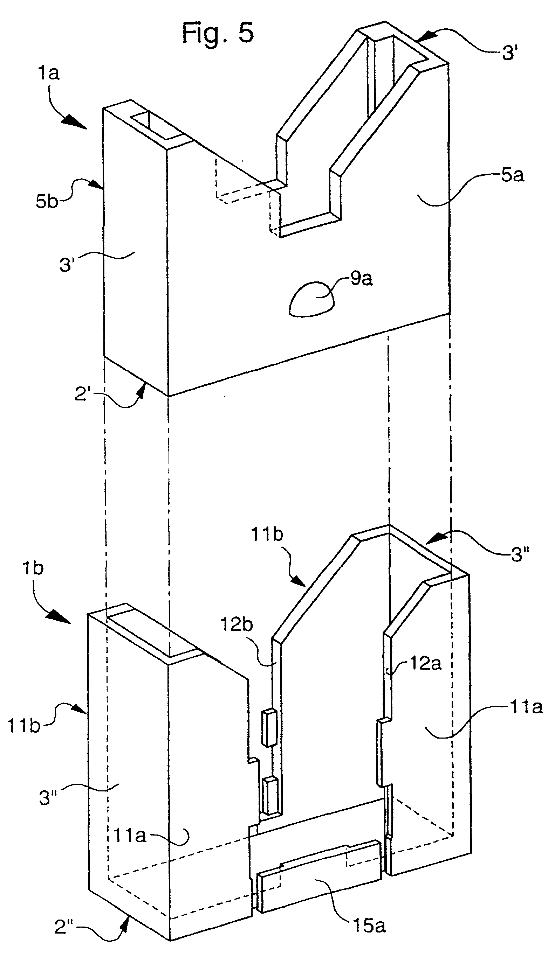

Le container 1 peut être obtenu en une seule pièce par moulage ou par injection d'un matériau plastique, mais il peut être économiquement plus avantageux pour la fabrication du moule de le fabriquer par assemblage de deux pièces ou davantage. A titre d'exemple la figure 5 représente un container tel que celui qui vient d'être décrit, obtenu par emboîtage de deux pièces 1a, 1b, formées par moulage ou injection d'un matériau plastique. La première pièce intérieure 1a comprend les parois de séparation 5a, 5b, une demi-base 2', deux petites demi-parois 3'. La deuxième pièce extérieure comprend les bandes 11a, 15a, 11b, 15b formant les logements 10a, 10b une demi-base 2" et des petites demi-parois 3". Ces demi-éléments de constructions ont sensiblement la moitié de l'épaisseur souhaitée pour les parois correspondantes 2, 3 après assemblage.

## Revendications

1. Support de pile-bouton à positionnement vertical sur une surface plane comprenant
- un container en matière isolante (1), ouvert vers le haut et délimité par une base rectangulaire (2), deux petites parois (3) et deux grandes parois (4a, 4b) verticales, et
- une première bride (20a) et une deuxième bride (20b) métalliques solidaires du container pour relier électriquement les pôles positif et négatif de la pile à des contacts ménagés sur la surface plane,
**caractérisé en ce que** chaque grande paroi (4a, 4b) est pourvue d'un logement (10a, 10b) pour assujettir verticalement une bride (20a, 20b) depuis l'extérieur du container, ledit logement (10a, 10b) étant formé d'une part d'une paroi de séparation (5a, 5b) comportant une découpe de communication (7a, 7b) avec l'intérieur du container et d'autre part de deux bandes verticales (11a, 11b) reliant les petites parois (3) et d'une bande horizontale (15a, 15b) reliant la base (2), lesdites bandes (11a, 11b, 15a, 15b) étant parallèles à la paroi de séparation (5a, 5b) et délimitant une ouverture (10a, 10b) et formant des décrochements de guidage (12a, 12b) et des moyens d'encliquetage (13a, 13b) de la bride, ladite bande horizontale (15a, 15b) étant en outre pourvue d'au moins un passage traversant (16a, 16b) au delà de la base (2) et ladite bride (20a, 20b) étant formée par une lame flexible prolongée à l'une de ses extrémités par au moins une patte de connexion (26a, 26b) engagée dans un passage traversant (16a, 16b), présentant au niveau de la découpe de communication (7a, 7b) une partie déformée en coude (27a, 27b) vers l'intérieur du container, et ayant sur chacun de ses bords des moyens d'encliquetage complémentaires (23a, 23b) de ceux des bandes, mais décalés verticalement par rapport à ceux-ci pour permettre la mise en place de la bride (20a, 20b) en la faisant glisser de haut en bas.

2. Support de pile-bouton selon la revendication 1, **caractérisé en ce que** les moyens d'encliquetage complémentaires sont formés par au moins une extension (13a, 13b) rectangulaire du bord de chaque bande verticale (11a, 11b) du logement (10a, 10b) et par au moins une encoche rectangulaire (23a, 23b) de même dimension pratiquée dans les bords de la bride (20a, 20b).

3. Support de pile-bouton selon la revendication 1, **caractérisé en ce que** chaque bride (20a, 20b) comprend en outre des moyens d'ancrage telles qu'une languette (24a, 24b) découpée et recourbée vers la paroi de séparation (5a, 5b) ou un évidemment (25a, 25b) dans lequel peut venir s'engager un bossage (9a, 9b) formé dans la paroi de séparation (5a, 5b).

4. Support de pile-bouton selon la revendication 1, **caractérisé en ce que** les brides (20a, 20b) établissant les jonctions électriques comportent chacune une seule patte de connexion (26b).

5. Support de pile-bouton selon la revendication 1, **caractérisé en ce que** la bride (20b) reliant le pôle négatif de la pile comporte une patte de connexion (26b) et la bride (20a) reliant le pôle positif comporte deux pattes (26a) de connexion.

6. Support de pile-bouton selon la revendication 1, **caractérisé en ce que** la bride (20a) établissant le contact avec le fond du boîtier d'une pile est prolongée par une languette (21) dont l'extrémité (22) est recourbée pour maintenir en place la pile-bouton à l'intérieur du container.

7. Support de pile-bouton selon la revendication 6, **caractérisé en ce que** l'extrémité (22) recourbée de la languette (21) est revêtue d'un manchon isolant (31), permettant de mettre en série deux piles-boutons (30a, 30b) dans un même support.

8. Support de pile-bouton selon la revendication 1, **caractérisé en ce que** deux angles à l'intérieur du container, situés d'un même côté d'une paroi de séparation comportent deux nervures (8) adaptées au caractère asymétrique de la pile-bouton.

9. Support de pile-bouton selon la revendication 1, **caractérisé en ce que** le container (1) est obtenu en une seule pièce par moulage ou injection d'un matériau plastique.

10. Support de pile-bouton selon la revendication 1, **caractérisé en ce que** le container (1) est formé de deux pièces emboîtables (1a, 1b), obtenues par moulage ou injection d'un matériau plastique, la première pièce intérieure (1a) comprenant les parois de séparation (5a, 5b), une demi base (2') et des petites demi-parois (3') et la deuxième pièce extérieure (1b) comprenant, les bandes (11a, 15a, 11b, 15b) formant les logements (10a, 10b), une demi-base (2") et des petites demi-parois (3") les demi-éléments formant après assemblage la base (2) et les petites parois (3).

## Claims

1. Support for a button type battery which can be vertically positioned on a flat surface including :
- a container (1) made of insulating material, open upwards and delimited by a rectangular base (2), two small walls (3) and two large vertical walls (4a, 4b), and
- a first metal clamp (20a) and a second metal clamp (20b) attached to said container to connect electrically the positive and negative poles of the battery to contacts arranged on the flat surface,
**characterised in that** each large wall (4a, 4b) is provided with a recess (10a, 10b) for securing a clamp (20a, 20b) vertically from the outside of the container, said recess (10a, 10b) being formed on the one hand of a separating wall (5a, 5b) including a cut out portion (7a, 7b) communicating with the inside of the container and on the other hand of two vertical strips (11a, 11b) connecting the small walls (3) and of a horizontal strip (15a, 15b) connecting the base (2), said strips (11a, 11b, 15a, 15b) being parallel to the separating wall (5a, 5b) and delimiting an opening (10a, 10b) and forming shoulder guide means (12a, 12b) and snap fitting means (15a, 15b) for the clamp, said horizontal strip (15a, 15b) being further provided with at least one passage (16a, 16b) passing through the base (2) and beyond it and said clamp (20a, 20b) being formed by a flexible metal strip extended at one of its ends by at least one connecting lug (26a, 26b) engaged in a through passage (16a, 16b), having in the vicinity of the cut out communication portion (7a, 7b) a deformed portion (27a, 27b) which is bent towards the inside of the container, and having on each of its edges snap fitting means (23a, 23b) complementary to the those of the strips, but offset vertically with respect thereto to allow the clamp (20a, 20b) to be set in place by sliding it from the top to the bottom.

2. Button type battery support according to claim 1, **characterised in that** the complementary snap fitting means are formed by at least one rectangular extension (13a, 13b) from the edge of each vertical strip (11a, 11b) of the recess (10a, 10b) and by at least one rectangular notch (23a, 23b) of the same dimensions made in the edges of the clamp (20a, 20b).

3. Button type battery support according to claim 1, **characterised in that** each clamp (20a, 20b) further includes anchoring means such as a tongue (24a, 24b) which is cut out and bent towards the separating wall (5a, 5b) or a recess (25a, 25b) in which a raised portion (9a, 9b) formed in the separation wall (5a, 5b) engages.

4. Button type battery support according to claim 1, **characterised in that** the clamps (20a, 20b) which establishes the electric junctions each includes a single connecting lug (26b).

5. Button type battery support according to claim 1, **characterised in that** the clamp (20b) connecting the negative pole of the battery includes a connecting lug (26b) and the clamp (20a) connecting the positive pole includes two connecting lugs (26a).

6. Button type battery support according to claim 1, **characterised in that** the clamp (20a) which establishes the contact with the base of a battery case is extended by a tongue (21) the end (22) of which is bent to hold the button type battery in place within the container.

7. Button type battery support according to claim 6, **characterised in that** the bent end (22) of the tongue (21) is covered with an insulating sleeve (31), allowing two button type batteries (30a, 30b) to be placed in series in a same support.

8. Button type battery support according to claim 1, **characterised in that** two angles within the container, situated on a same side of a separating wall include two ribs (8) fitted to the asymmetrical nature of the button type battery.

9. Button type battery support according to claim 1, **characterised in that** the container (1) is obtained in a single part by moulding or injecting a plastic material.

10. Button type battery support according to claim 1, **characterised in that** the container (1) is formed of two parts (1a, 1b) which fit together, obtained by moulding or injecting a plastic material, the first inner part (1a) including the separation walls (5a, 5b), a semi base (2') and small semi walls (3') and the second outer part (1b) including the strips (11a, 15a, 11b, 15b) forming the recesses (10a, 10b), a semi base (2") and small semi walls (3") the semi elements forming, after assembly, the base (2) and the small walls (3).

## Patentansprüche

1. Knopfzellenhalter mit vertikaler Positionierung auf einer ebenen Oberfläche, der umfasst:
- einen Behälter (1) aus Isoliermaterial, der nach oben offen ist und durch eine rechtwinklige Basis (2), zwei vertikale kleine Wände (3) und zwei vertikale große Wände (4a, 4b) begrenzt ist, und
- einen ersten Metallbügel (20a) und einen zweiten Metallbügel (20b), die mit dem Behälter verbunden sind, um den positiven Pol und den negativen Pol der Zelle mit Kontakten, die auf der ebenen Oberfläche ausgebildet sind, elektrisch zu verbinden,
**dadurch gekennzeichnet, dass** jede große Wand (4a, 4b) mit einem Aufnahmesitz (10a, 10b) versehen ist, um einen Bügel (20a, 20b) von außerhalb des Behälters vertikal festzuklemmen, wobei der Aufnahmesitz (10a, 10b) einerseits aus einer Trennwand (5a, 5b), die einen Ausschnitt (7a, 7b) für eine Verbindung mit dem Innenraum des Behälters aufweist, und andererseits aus zwei vertikalen Bändern (11a, 11b), die mit den kleinen Wänden (3) verbunden sind, und aus einem horizontalen Band (15a, 15b), das mit der Basis (2) verbunden ist, gebildet ist, wobei die Bänder (11a, 11b, 15a, 15b) zu der Trennwand (5a, 5b) parallel sind und eine Öffnung (10a, 10b) begrenzen und Führungsrücksprünge (12a, 12b) sowie Mittel (13a, 13b) zum Einrasten des Bügels bilden, wobei das horizontale Band (15a, 15b) außerdem mit wenigstens einem Durchlass (16a, 16b) über der Basis (2) versehen ist und der Bügel (20a, 20b) durch ein flexibles Plättchen gebildet ist, das an einem seiner Enden durch wenigstens einen Verbindungsansatz (26a, 26b) verlängert ist, der in einem Durchlass (16a, 16b) in Eingriff ist, und auf Höhe des Verbindungsausschnitts (7a, 7b) einen in den Innenraum des Behälters gebogenen Verformungsabschnitt (27a, 27b) aufweist und an jedem seiner Ränder Einrastmittel (23a, 23b) aufweist, die zu jenen des Bandes komplementär sind, jedoch in Bezug darauf vertikal versetzt sind, um die Anordnung des Bügels (20a, 20b) in der Weise zu ermöglichen, dass er von oben nach unten gleitet.

2. Knopfzellenhalter nach Anspruch 1, **dadurch gekennzeichnet, dass** die komplementären Einrastmittel durch wenigstens eine rechtwinklige Verlängerung (13a, 13b) des Randes jedes vertikalen Bandes (11a, 11b) des Aufnahmesitzes (10a, 10b) und durch wenigstens eine rechtwinklige Nut (23a, 23b) mit gleicher Abmessung, die in den Rändern des Bügels (20a, 20b) ausgespart ist, gebildet sind.

3. Knopfzellenhalter nach Anspruch 1, **dadurch gekennzeichnet, dass** jeder Bügel (20a, 20b) außerdem Verankerungsmittel wie etwa eine Zunge (24a, 24b), die ausgestanzt und zu der Trennwand (5a, 5b) umgebogen ist, oder eine Aussparung (25a, 25b), mit der eine in der Trennwand (5a, 5b) ausgebildete Erhebung (9a, 9b) in Eingriff gelangen kann, umfasst.

4. Knopfzellenhalter nach Anspruch 1, **dadurch gekennzeichnet, dass** die Bügel (20a, 20b), die elektrische Anschlüsse bilden, jeweils einen einzigen Verbindungsansatz (26b) aufweisen.

5. Knopfzellenträger nach Anspruch 1, **dadurch gekennzeichnet, dass** der Bügel (20b), der den negativen Pol der Zelle verbindet, einen Anschlussansatz (26b) aufweist und der Bügel (20a), der den positiven Pol verbindet, zwei Anschlussansätze (26a) aufweist.

6. Knopfzellenhalter nach Anspruch 1, **dadurch gekennzeichnet, dass** der Bügel (20a), der den Kontakt mit dem Boden des Behälters einer Zelle herstellt, durch eine Zunge (21) verlängert ist, deren Ende (22) umgebogen ist, um die Knopfzelle im Innenraum des Behälters zu halten.

7. Knopfzellenhalter nach Anspruch 6, **dadurch gekennzeichnet, dass** das umgebogene Ende (22) der Zunge (21) mit einer Isoliermuffe (31) überzogen ist, die ermöglicht, zwei Knopfzellen (30a, 30b) im selben Halter in Reihe anzuordnen.

8. Knopfzellenhalter nach Anspruch 1, **dadurch gekennzeichnet, dass** zwei Ecken im Innenraum des Behälters, die sich auf derselben Seite einer Trennwand befinden, zwei Rippen (8) aufweisen, die an den asymmetrischen Charakter der Knopfzelle angepasst sind.

9. Knopfzellenhalter nach Anspruch 1, **dadurch gekennzeichnet, dass** der Behälter (1) durch Gießen oder Spritzen von Kunststoff einteilig erhalten wird.

10. Knopfzellenhalter nach Anspruch 1, **dadurch gekennzeichnet, dass** der Behälter (1) aus zwei ineinandersteckbaren Teilen (1a, 1b) gebildet ist, die durch Gießen oder Spritzen von Kunststoff erhalten werden, wobei das erste innere Teil (1a) die Trennwände (5a, 5b), eine Halbbasis (2') und kleine Halbwände (3') umfasst und das zweite äußere Teil (1b) die Bänder (11 a, 15a, 11b, 15b), die die Aufnahmesitze (10a, 10b) bilden, eine Halbbasis (2") und kleine Halbwände (3") umfasst, wobei die Halbelemente nach der Zusammenfügung die Basis (2) und die kleinen Wände (3) bilden.
